Europäisches Patentamt

(19) European Patent Office

Office européen des brevets

(11) Publication number: **0 014 528**
**B1**

(12) **EUROPEAN PATENT SPECIFICATION**

(45) Date of publication of patent specification: **30.03.83**

(21) Application number: **80300144.5**

(22) Date of filing: **15.01.80**

(51) Int. Cl.³: **C 30 B 33/00,**
**C 01 B 31/06, G 21 H 5/00**

(54) **A method of reducing the colour of diamond.**

(30) Priority: **17.01.79 GB 7901728**

(43) Date of publication of application:
**20.08.80 Bulletin 80/17**

(45) Publication of the grant of the patent:
**30.03.83 Bulletin 83/13**

(84) Designated Contracting States:
**BE DE FR GB NL**

(56) References cited:
**GB - A - 660 719**
**US - A - 2 945 793**
**US - A - 2 998 365**
**US - A - 4 124 690**

(73) Proprietor: **DE BEERS INDUSTRIAL DIAMOND**
**DIVISION (PROPRIETARY) LIMITED**
**8th Floor 45 Main Street**
**Johannesburg Transvaal (ZA)**

(72) Inventor: **Evans, Trevor**
**8 Oaklands**
**Bulmershe Road Reading (GB)**
Inventor: **Allen, Brian Philip**
**52 Leicester Road**
**Sapcote Leicestershire (GB)**

(74) Representative: **Ellis-Jones, Patrick George Armine**
**et al,**
**J.A. KEMP & CO. 14 South Square Gray's Inn**
**London WC1R 5EU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## A method of reducing the colour of diamond

This invention relates to diamond treatment and more particularly to a method of reducing the colour of diamond of type 1b.

Diamond of type 1b contains dispersed nitrogen and this imparts to the diamond a colour ranging from yellow to green. Most synthetic diamonds are of the type 1b. Diamond of type 1a, on the other hand, contains nitrogen in an aggregated form. Such diamonds are colourless or yellow.

It is known from US—A—2 998 365 that it is possible to reduce the colour of diamonds by irradiation to cause rearrangement of the crystal lattice. The irradiation is said to compensate for the existing colour by creating colour at the other end of the visible spectrum. It is also said that when some types of irradiation, notably gamma irradiation there is an overcompensation. This over-irradiation can be cancelled out by subsequent heating to a temperature of up to 600°C. There is no suggestion that this heat treatment should be carried out except where there is over-irradiation.

Moreover, the heat treatment does no more than correct colour introduced by the over-irradiation. The colour must be maintained because it is this colour which counteracts the absorption at the other end of the spectrum.

Much more recently it has become known (see US—A—4 124 690) to anneal type 1b diamonds at a temperature from about 1500° to 2200°C under a sufficient pressure to prevent graphitisation, thereby converting the diamond at least partially to type 1a. No mention is made of the possibility of carrying out an irradiation step. [Of course US—A—2 998 365 is concerned with natural diamonds (synthetic diamonds then being unknown) and these are almost all of type 1a already].

It has now surprisingly been found that if one irradiates and then anneals type 1b diamonds under conditions similar to those described in US—A—4 124 690 a much more effective reduction in colour occurs.

According to the present invention, a method of reducing the colour of diamond of type 1b includes the step of exposing the diamond to irradiation capable of causing atomic displacements in the diamond, namely irradiation of a flux so as to produce at least $10^{18}$ vacancies per cubic centimeter in the diamond, followed by heat treatment at a temperature in the range 1600°C to 2200°C under a pressure at which diamond is crystallographically stable at the temperature used.

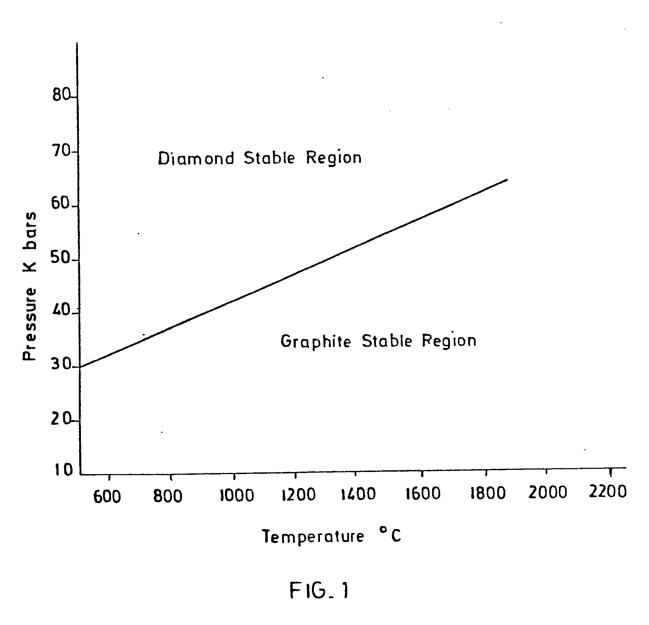

The pressure at which the heat treatment takes place is that at which diamond is crystallographically stable at the particular temperature used. The use of this pressure prevents, or prevents any significant, graphitisation of the diamond. The pressures which can be employed for any particular temperature of heat treatment are easily ascertainable from the carbon phase diagram which is illustrated graphically by Figure 1.

The apparatus which is used to effect heat treatment under pressure can be any high temperature/pressure apparatus well known in the art.

The irradiation may be electron bombardment of energy greater than 300 KeV. Preferably, the energy of the electron bombardment is greater than 1 MeV, typically 2 MeV.

The irradiation may also be with other particles of sufficient energy to produce atomic displacements in diamond such as neutron bombardment or gamma irradiation.

The period of heat treatment will vary according to the degree of reduction in colour desired. Generally, however, the period of heat treatment will not normally exceed two hours. The preferred temperature of heat treatment is in the range 1900°C to 2200°C.

The invention has particular application to synthetic diamonds, particularly large ones of gem stone quality.

The treatment of synthetic diamonds of Type 1b according to the invention produces platelets in the diamond which are similar to platelets in natural diamonds. These platelets are in the (100) planes with a diameter of 100 Å and at a concentration of about $10^{14}$ per cc. The platelets show the same features under diffraction in the electron microscope as platelets of natural diamonds.

The results of certain experiments are given hereinbelow.

### Experimental results

| Specimen treatment | Results—U.V. absorption |
| --- | --- |
| (Total time) | |
| HN1 | |
| $\frac{3}{4}$ hour at 1950°C | absorption edge initially at 22000 cm$^{-1}$ |
| | absorption edge at 23600 cm$^{-1}$ |
| 2 hours 10 minutes at 1950°C | absorption edge at 25200 cm$^{-1}$ |
| | and $\mu 25000 = 100$ cm$^{-1}$ |
| 4 hours 25 minutes at 1950°C | $\mu 25000 = 70$ cm$^{-1}$ |
| 5 hours 35 minutes at 1950°C | $\mu 25000 = 45$ cm$^{-1}$ |
| +15 minutes at 2150°C | $\mu 25000 = 24$ cm$^{-1}$ |
| HN4 | |
| 1 hour 50 minutes at 2050°C | absorption edge initially at ~22000 cm$^{-1}$ |
| | absorption edge at ~24200 cm$^{-1}$ |
| HN10 | |
| 27 hours electron irradiation at 2 MeV followed by | absorption edge initially at 22000 cm$^{-1}$ |
| 20 minutes at about ~2050°C | absorption edge at 34,000 cm$^{-1}$ |
| | and $\mu 25000 = 26$ cm$^{-1}$ |
| HN6 | |
| $33\frac{1}{2}$ hours electron irradiation at 2 MeV followed by | absorption edge at 22,000 cm$^{-1}$ |
| 30 minutes at 2000°C | absorption edge at 34,000 cm$^{-1}$ |
| | and $\mu 25000 = 39$ cm$^{-1}$ |

In all the above experiments, the pressure used for the heat treatment was 80 Kbars and the apparatus was conventional high temperature/pressure apparatus.

The significant reduction in colour of the diamonds for experiments HN 10 and HN 6 (using the method of the invention) will be noted, as seen from the change in the absorption edge. In all experiments the starting diamond was synthetic diamond of type 1b.

The absorption edges moves to high frequencies during heat treatment due to the nitrogen in the number of single substitutional nitrogen atoms in the diamond lattice. This reduction is caused by the aggregation of single nitrogen atoms.

## Claims

1. A method of reducing the colour of diamond of type 1b including the steps of exposing the diamond to irradiation of a flux so as to produce at least $10^{18}$ vacancies per cubic centimeter in the diamond followed by heat treating the irradiated diamond at a temperature in the range 1600°C to 2200°C under a pressure at which diamond is crystallographically stable at the temperature used.

2. A method of claim 1 wherein the irradiation is electron bombardment of energy greater than 300 KeV.

3. A method of claim 2 wherein the energy of the electron bombardment is greater than 1 MeV.

4. A method of claim 2 wherein the energy of the electron bombardment is 2 MeV.

5. A method of claim 1 wherein the irradiation is neutron bombardment or gamma irradiation.

6. A method of any one of the preceding claims wherein the temperature of the heat treatment is in the range 1900°C to 2200°C.

7. A method according to any one of the preceding claims wherein the diamond is synthetic diamond.

## Revendications

1. Méthode de réduction de la coloration du diamant de type 1b comportant les étapes suivantes: l'exposition du diamant à l'irradiation par un flux tel qu'il produise au moins $10^{18}$ lacunes par centimètre cube dans le diamant suivie par un traitement thermique du diamant irradié à une température comprise entre 1600°C et 2200°C sous une pression qui assure la stabilité cristallographique du diamant à la température employée.

2. Méthode selon la revendication 1, dans laquelle l'irradiation est une bombardement électronique d'énergie supérieure à 300 KeV.

3. Méthode selon la revendication 2 dans laquelle l'énergie du bombardment électronique est supérieure à 1 MeV.

4. Méthode selon la revendication 2, dans laquelle l'énergie du bombardement électronique est de 2 MeV.

5. Méthode selon la revendication 1 dans laquelle l'irradiation est une bombardement neutronique ou une irradiation gamma.

6. Méthode selon l'une quelconque des précédentes revendications dans laquelle la température au cours du traitement thermique est comprise entre 1900°C et 2200°C.

7. Méthode selon l'une quelconque des revendications précédentes dans laquelle le diamant est un diamant synthétique.

## Patentansprüche

1. Ein Verfahren zum Abschwächen der Farbe von Diamanten der Type 1b, dadurch gekenn-

zeichnet, daß der Diamant einer Bestrahlung mit einem derartigen Energiestrom ausgesetzt wird, daß wenigstens $10^{18}$ Gitterlücken pro $cm^3$ im Diamant erzeugt werden, daß der bestrahlte Diamant anschließend bei einer Temperatur von 1600°C bis 2200°C unter einem Druck warmbehandelt wird, bei welchem der Diamant bei der angewendeten Temperatur kristallografisch stabil ist.

2. Ein Verfahren nach Anspruch 1, dadurch gekennzeichnet, daß es sich bei der Bestrahlung um einen Elektronenbeschuß mit einer Energie von mehr als 300 KeV handelt.

3. Ein Verfahren nach Anspruch 2, dadurch gekennzeichnet, daß die Energie des Elektronenbeschusses mehr als 1 MeV beträgt.

4. Ein Verfahren nach Anspruch 2, dadurch gekennzeichnet, daß die Energie des Elektronenbeschusses 2 MeV beträgt.

5. Ein Verfahren nach Anspruch 1, dadurch gekennzeichnet, daß es sich bei der Bestrahlung um Neutronenbeschuß oder Gammabestrahlung handelt.

6. Ein Verfahren nach einem der vorhergehenden Ansprüche, dadurch gekennzeichnet, daß die Temperatur der Warmbehandlung zwischen 1900°C und 2200°C beträgt.

7. Ein Verfahren nach einem der vorhergehenden Ansprüche, dadurch gekennzeichnet, daß der Diamant ein synthetischer Diamant ist.

0 014 528

FIG. 1